(19) Europäisches Patentamt
European Patent Office
Office européen des brevets

(11) **EP 1 410 505 B1**

(12) **EUROPÄISCHE PATENTSCHRIFT**

(45) Veröffentlichungstag und Bekanntmachung des Hinweises auf die Patenterteilung:
**25.03.2009 Patentblatt 2009/13**

(21) Anmeldenummer: 02708181.9

(22) Anmeldetag: **29.01.2002**

(51) Int Cl.:
***H03K 17/10*** *(2006.01)*

(86) Internationale Anmeldenummer:
**PCT/DE2002/000307**

(87) Internationale Veröffentlichungsnummer:
**WO 2003/012996 (13.02.2003 Gazette 2003/07)**

(54) **SCHALTEINRICHTUNG ZUM SCHALTEN BEI EINER HOHEN BETRIEBSSPANNUNG**

SWITCHING DEVICE FOR A SWITCHING OPERATION AT A HIGH WORKING VOLTAGE

DISPOSITIF DE COMMUTATION POUR COMMUTATION EN PRESENCE D'UNE TENSION DE FONCTIONNEMENT ELEVEE

(84) Benannte Vertragsstaaten:
**AT BE CH CY DE DK ES FI FR GB GR IE IT LI LU MC NL PT SE TR**

(30) Priorität: **23.07.2001 DE 10135835**

(43) Veröffentlichungstag der Anmeldung:
**21.04.2004 Patentblatt 2004/17**

(73) Patentinhaber: **SiCED Electronics Development GmbH & Co KG**
**91052 Erlangen (DE)**

(72) Erfinder:
• **MITLEHNER, Heinz**
**91080 Uttenreuth (DE)**
• **FRIEDRICHS, Peter**
**90475 Nürnberg (DE)**

(74) Vertreter: **Maier, Daniel Oliver et al**
**Siemens AG**
**CT IP Com E**
**Postfach 22 16 34**
**80506 München (DE)**

(56) Entgegenhaltungen:
**US-A- 5 406 096**

• **PATENT ABSTRACTS OF JAPAN vol. 011, no. 148 (E-506), 14. Mai 1987 (1987-05-14) & JP 61 285770 A (TOSHIBA CORP), 16. Dezember 1986 (1986-12-16)**
• **PATENT ABSTRACTS OF JAPAN vol. 004, no. 175 (E-036), 3. Dezember 1980 (1980-12-03) & JP 55 121682 A (NEC CORP), 18. September 1980 (1980-09-18)**

**Beschreibung**

Die Erfindung betrifft eine Schalteinrichtung zum Schalten bei einer hohen Betriebsspannung und umfasst mindestens ein Niedervolt(NV)-Schaltelement mit einem NV-Kathodenanschluss, einem NV-Anodenanschluss und einem NV-Gitteranschluss, ein erstes Hochvolt(HV)-Schaltelement mit einem ersten HV-Kathodenanschluss, einem ersten HV-Anodenanschluss und einem ersten HV-Gitteranschluss, wobei der NV-Anodenanschluss mit dem ersten HV-Kathodenanschluss und der NV-Kathodenanschluss mit dem ersten HV-Gitteranschluss elektrisch kurzgeschlossen ist.

So eine Schalteinrichtung ist aus der US 6,157,049 sowie aus der EP 0 063 749 B1 und JP 61 285 770 bekannt. Die jeweils offenbarte elektronische Schalteinrichtung basiert auf der genannten speziellen Zusammenschaltung des NV- und des HV-Schaltelements. Sie wird auch als Kaskoden-Schaltung bezeichnet. Die Schalteinrichtung dient zum Schalten eines hohen elektrischen Stroms und ist auch in der Lage, eine hohe Betriebsspannung sicher zu sperren. Das NV-Schaltelement, ein selbstsperrender (= normally off) MOSFET, besteht aus Silicium (Si) und sorgt dafür, dass die Zusammenschaltung mit dem als selbstleitender (= normally on) JFET ausgebildeten HV-Schaltelement eine selbstsperrende Einheit ergibt. Das HV-Schaltelement besteht aus einem Halbleitermaterial mit einer Durchbruchfeldstärke von mehr als $10^6$ V/cm. Das HV-Schaltelement nimmt dann im Sperrfall den wesentlichen Teil der an der Kaskoden-Schaltung anstehenden zu sperrenden Spannung auf. Besonders eignet sich das Halbleitermaterial Siliciumcarbid (SiC) als Ausgangsmaterial für das HV-Schaltelement.

In der Umrichtertechnik, die beispielsweise auch in einem drehzahlveränderbaren Antrieb zum Einsatz kommt, wird eine Schalteinrichtung benötigt, die bei einer hohen Leistung, d.h. im Allgemeinen auch bei einer hohen Betriebsspannung, einen hohen Wirkungsgrad möglichst nahe 100 % erreicht. Wenn die Schalteinrichtung möglichst geringe statische und dynamische Verluste aufweist, wird eine nahezu optimale Energieausnutzung und damit einhergehend eine deutliche Reduzierung des erforderlichen Kühlaufwandes erreicht.

Üblicherweise kommt in der Umrichtertechnik derzeit als HV-Schaltelement im Spannungsbereich bis 6,5 kV ein Silicium-IGBT (Insolated Gate Bipolar Transistor) oder ein Silicium-GTO (Gate Turn Off)-Thyristor und in einem Spannungsbereich bis etwa 10 kV ein Silicium-Thyristor zum Einsatz. Bei diesen Schaltelementen handelt es sich jedoch um bipolare Halbleiterbauelemente, die strukturbedingt beim Schalten aufgrund eines unvermeidlichen Speicherladungseffekts sowohl eine gewisse Verzögerungszeit als auch nennenswerte dynamische Schaltverluste aufweisen.

Dieses Problem umgeht eine nur mit unipolaren Schaltelementen, also beispielsweise mit Feldeffekttransistoren, aufgebaute Kaskoden-Schaltung. Neben ohnehin niedrigem statischen Verlust zeichnet sich ein unipolares Schaltelement aufgrund der fehlenden Speicherladungseffekte auch durch eine geringe Schaltzeit und durch geringe dynamische Verluste aus. Bei einem HV-Schaltelement, das als ein in SiC realisierter Sperrschicht-Feldeffekttransistor ausgebildet ist, lässt sich die maximal zulässige Sperrspannung auf zweierlei Art und Weise erreichen. Zum wird die Driftzone verlängert. Dies ist bei einem vertikalen Sperrschicht-Feldeffekttransistor gleichbedeutend mit dem Aufwachsen einer dickeren Epitaxieschicht auf dem verwendeten Substrat. Zum anderen wird auch die Dotierstoffkonzentration innerhalb der Epitaxieschicht reduziert. Beide im Hinblick auf die maximal zulässige Sperrspannung günstige Maßnahmen bewirken jedoch eine Erhöhung des ohmschen Driftwiderstandes. Dies führt im Durchlasszustand (geschlossenes Schaltelement) zu einer höheren statischen Verlustleistung, die thermisch abgeführt wird. Deshalb ist eine Kaskoden-Schaltung, die unter Verwendung eines unipolaren HV-Schaltelements aus SiC realisiert ist, derzeit auf eine maximal zulässige Sperrspannung in der Größenordnung von typischerweise 3,5 kV beschränkt. Grundsätzlich ist jedoch auch eine noch höhere Sperrspannung, beispielsweise von 5 kV möglich.

Wird eine Schalteinrichtung für eine höhere Sperrspannung benötigt, ist dies derzeit nur durch mehrere in Serie geschaltete Kaskoden-Glieder, die in der beschriebenen Weise mit unipolaren Schaltelementen aufgebaut sind, oder durch eine Reihenschaltung mehrerer unipolarer Schaltelemente oder durch den Einsatz der beschriebenen bipolaren Silicium-Schaltelemente möglich. Ein bipolares Schaltelement führt wie bereits beschrieben zu einer höheren Schaltzeit und zu höheren dynamischen Verlusten.

Bei der Reihenschaltung mehrerer Kaskoden-Schaltungen wird für das NV-Schaltelement jeder Kaskoden-Schaltung eine eigene Ansteuerung benötigt. Erschwerend kommt hinzu, dass diese aktiven Ansteuerungen auch auf unterschiedlichem elektrischen Potential liegen. Dadurch ergibt sich ein nicht unerheblicher schaltungstechnischer Aufwand, der auch zu höheren Kosten führt.

Weiterhin ist aus der DE 199 26 109 A1 eine Schalteinrichtung für eine höhere Sperrspannung auf Basis einer modifizierten Kaskoden-Schaltung bekannt. Die Kaskoden-Schaltung wird hierbei dadurch verändert, dass in die ursprünglich zwischen dem NV-Kathodenanschluss und dem ersten HV-Gitteranschluss vorgesehene Kurschlussverbindung ein zusätzliches Schaltelement in Form eines Hilfstransistors eingefügt wird. Dadurch soll das NV-Schaltelement eine höhere Sperrspannung aufnehmen, ehe auch das HV-Schaltelement in seinem sperrenden Zustand umgeschaltet wird, so dass eine insgesamt erhöhte Sperrspannung durch die modifizierte Kaskoden-Schaltung aufgenommen werden kann. Eine Weiterbildung dieser modifizierten Kaskoden-Schaltung besteht darin, weitere HV-Schaltelemente in Reihe zu dem ersten HV-Schaltelement der modifizierten Kaskoden-schaltung zu schalten. Zwischen den Steueranschlüssen dieser weiteren Schaltelemente ist jeweils ein weiterer Hilfstransistor vorgesehen. Zusätzlich können zur Absicherung, insbesondere zur Begrenzung der Potentiale an den Steueranschlüssen, Schutzelemente in Form von Zenerdioden vorgesehen sein. Auch diese Schalteinrichtung ist gerade aufgrund der in der DE 199 26 109 A1 als erfindungswesentlich gekennzeichneten Hilfstransistoren mit einem nicht unerheblichen Schaltungsaufwand verbunden.

Es ist nun Aufgabe der Erfindung, eine Schalteinrichtung der eingangs bezeichneten Art anzugeben, die eine hohe Sperrspannung aufweist und gleichzeitig mit einem geringen schaltungstechnischen Aufwand realisiert werden kann.

Diese Aufgabe wird erfindungsgemäß gelöst mit den kennzeichnenden Merkmalen des Anspruchs 1.

Die eingangs bezeichnete Schalteinrichtung ist gekennzeichnet durch mindestens noch ein zweites HV-Schaltelement mit einem zweiten HV-Kathodenanschluss, einem zweiten HV-Anodenanschluss und einem zweiten HV-Gitteranschluss, wobei das zweite HV-Schaltelement in Reihe zum ersten HV-Schaltelement geschaltet ist, und zwischen den ersten und den zweiten HV-Gitteranschluss ein erstes Schutzelement geschaltet ist.

Die Erfindung beruht auf der Erkenntnis, dass die Sperrspannungsfestigkeit einer Kaskoden-Schaltung aus einem NV-Schaltelement und einem ersten HV-Schaltelement auf einfache Weise und auch skalierbar gesteigert werden kann, indem ein weiteres HV-Schaltelement oder auch mehrere weitere HV-Schaltelemente in Reihe zu der Kaskoden-Schaltung, d.h. insbesondere in Reihe zu dem ersten HV-Schaltelement, vorgesehen ist bzw. sind. Im Falle nur eines weiteren HV-Schaltelements führt das zwischen die Gitteranschlüsse der beiden HV-Schaltelemente geschaltete erste Schutzelement dazu, dass das ansonsten bei einer Reihenschaltung eines weiteren Kaskoden-Glieds zur Beschaltung des weiteren HV-Schaltelements erforderliche weitere NV-Schaltelement ebenso wenig benötigt wird wie eine gesonderte Ansteuerung für dieses weitere NV-Schaltelement. Vielmehr bewirkt die Beschaltung mit dem Schutzelement einen automatischen Mitnahmeeffekt: auch das weitere HV-Schaltelement geht nämlich in den Sperrzustand über, sobald das erste HV-Schaltelement über das extern angesteuerte NV-Schaltelement in seinen sperrenden Zustand versetzt wird. Das Schutzelement ist dabei insbesondere so zwischen die beiden HV-Gitteranschlüsse geschaltet, dass es in Richtung vom ersten zum zweiten HV-Gitteranschluss ein Durchlassverhalten und in umgekehrter Richtung ein Sperrverhalten aufweist.

Durch die grundsätzlich mögliche Serienschaltung beliebiger weiterer HV-Schaltelemente kann damit über die Anzahl der in Serie geschalteten HV-Schaltelemente eine Schalteinrichtung realisiert werden, die sich zum Schalten bei einer hohen Betriebsspannung eignet und die insbesondere auch eine hohe Sperrspannung aufweist. Unter einer hohen Spannung wird in diesem Fall insbesondere eine Spannung von mehr als 1000 V, vorzugsweise von mehr als 3,5 kV verstanden. Weiterhin ist auch der erforderliche Schaltungsaufwand gegenüber einer Serienschaltung einzelner Kaskoden-Glieder inklusive deren Ansteuerschaltungen deutlich reduziert, da zum einen keine weiteren NV-Schaltelemente und auch keine weiteren externen Ansteuerungen benötigt werden. Damit reduziert sich auch der Platzbedarf für die Schalteinrichtung.

Besondere Ausgestaltungen der Schalteinrichtung ergeben sich aus den von Anspruch 1 abhängigen Ansprüchen.

Günstig ist eine Ausführungsform, bei der neben einem zweiten HV-Schaltelement noch ein drittes HV-Schaltelement in Serie zu den ersten beiden HV-Schaltelementen geschaltet ist. Dadurch lässt sich die insgesamt erzielbare maximal zulässige Sperrspannung weiter erhöhen. Das dritte HV-Schaltelement hat einen dritten HV-Kathodenanschluss, einen dritten HV-Anodenanschluss und einen dritten HV-Gitteranschluss. Insbesondere vorteilhaft ist es, wenn im Zusammenhang mit der weiteren Beschaltung mit dem dritten HV-Schaltelement auch ein zusätzliches, d.h. ein zweites Schutzelement vorgesehen wird. Dieses zweite Schutzelement ist dann zwischen den dritten HV-Gitteranschluss und einen der beiden anderen HV-Gitteranschlüsse geschaltet. Hier ist sowohl die Schaltungsvariante mit einem Anschluss an den ersten HV-Gitteranschluss als auch die mit einem Anschluss an den zweiten HV-Gitteranschluss möglich. Durch das zweite Schutzelement wird der vorteilhafte Mitnahmeeffekt ebenfalls auf das dritte HV-Schaltelement ausgedehnt, so dass auch das dritte HV-Schaltelement in seinen Sperrzustand überwechselt, sobald das zweite Schaltelement die im Zusammenhang mit dieser Ausführungsform der Schalteinrichtung vorgegebene maximale Sperrspannung erreicht hat. Weitere HV-Schaltelemente und Schutzelemente können in analoger Weise der Schalteinrichtung hinzugefügt werden, um eine höhere maximal zulässige Sperrspannung zu erreichen.

Bei einer günstigen Ausführungsform weist das Schutzelement in Sperrrichtung ab einer bestimmten, am Schutzelement anliegenden Spannung ein Durchbruchverhalten auf. Ab dieser sogenannten Schutzelement-Durchbruchspannung wird der Strom nicht mehr gesperrt, sondern es kommt auch in Sperrrichtung zu einem Stromfluss über das Schutzelement. Dieses Durchbruchverhalten ist insbesondere deshalb vorteilhaft, da gerade der ab dieser Schutzelement-Durchbruchspannung fließende Sperrstrom das zweite oder auch das dritte HV-Schaltelement dazu veranlasst, vom leitenden in den sperrenden Zustand umzuschalten. Eine besonders einfache Ausführungsform des Schutzelements ergibt sich in Form einer Diode. Möglich ist hierbei der Einsatz einer einfachen pn-Diode aus Silicium. Insbesondere eine Avalanche-Diode aus Silicium weist das beschriebene vorteilhafte Durchbruchverhalten auf. Derartige Avalanche-Dioden sind für verschiedene Schutzelement-Durchbruchspannungen erhältlich.

Bevorzugt ist es eine weitere Variante, bei der zwischen den zweiten HV-Kathodenanschluss und den zweiten HV-Gitteranschluss ein Überspannungsschutzelement geschaltet ist. Dadurch erreicht man eine Überspannungssicherheit am zweiten HV-Schaltelement. Analog kann natürlich auch ein entsprechendes Überspannungsschutzelement an jedem außerdem vorhandenen weiteren HV-Schaltelement vorgesehen sein. Eine besonders günstige Realisierungsform für das Überspannungsschutzelement ist eine Z-Diode.

Vorzugsweise ist zumindest eines der verwendeten HV-Schaltelemente auf Basis des Halbleitermaterials Siliciumcarbid (SiC) realisiert. Aufgrund der hohen Durchbruchfeldstärke von SiC sind mit diesem Halbleitermaterial sehr hohe Sperrspannungen zu erreichen. Als Ausgangsmaterial kann dabei Siliciumcarbid in einer seiner verschiedenen Polytyp-Ausprägungen, insbesondere als 3C-, 4H-, 6H- und 15R-SiC, eingesetzt werden.

Eine weitere vorteilhafte Ausgestaltungsform beinhaltet ein als selbstleitender Feldeffekttransistor ausgebildetes HV-Schaltelement. Dadurch lässt sich der über die Schalteinrichtung fließende Strom sehr einfach und schnell steuern. Aufgrund der unipolaren Eigenschaft eines Feldeffekttransistors sind sehr kurze Schaltzeiten und geringe dynamische Verluste möglich. Eine besonders günstige Ausführungsform ist der selbstleitende Sperrschicht-Feldeffekttransistor (JFET). Eine in diesem Zusammenhang geeignete JFET-Struktur ist in der US 6,034,385 oder in der DE 198 33 214 C1 beschrieben. Grundsätzlich sind jedoch auch andere Strukturen für den Sperrschicht-Feldeffekttransistor denkbar.

Günstig ist eine Variante, bei der die Schutzelement-Durchbruchspannung so gewählt ist, dass die HV-Schaltelemente, zu deren Schutz die Schutzelemente vorgesehen sind, sicher vor einem Durchbruch geschützt werden. Dazu wird die Schutzelement-Durchbruchspannung jeweils so dimensioniert, dass sie kleiner ist als die Summe aller Schaltelement-Durchbruchspannungen derjenigen Schaltelemente, denen das jeweilige Schutzelement parallel geschaltet ist. Hierbei ist zu beachten, dass das Schutzelement nicht nur den HV-Schaltelementen, sondern auch dem NV-Schaltelement der Kaskoden-Schaltung parallel geschaltet ist. Somit ist auch dessen, wenn auch sehr niedrige Durchbruchspannung bei dieser Dimensionierungsvorschrift für die Schutzelement-Durchbruchspannung zu berücksichtigen.

Ein noch effektiverer Schutz vor Durchbruch wird für die durch das Schutzelement geschützten HV-Schaltelemente in einer weiteren Ausführungsform erreicht, indem bei der Dimensionierungsvorschrift für die Schutzelement-Durchbruchspannung im Falle eines als selbstleitender Feldeffekttransistor ausgebildeten HV-Schaltelements auch die sogenannte Abschnürspannung (pinch off-Spannung) des selbstleitenden Feldeffekttransistors mit berücksichtigt wird. Die Abschnürspannung gibt den Spannungswert einer zwischen dem HV-Kathodenanschluss und dem HV-Gitteranschluss des selbstleitenden Feldeffekttransistors anstehenden Spannung an, ab dem ein Stromfluss im selbstleitenden Feldeffekttransistor zwischen dem HV-Kathoden- und dem HV-Anodenanschluss sicher unterbunden wird. Zu berücksichtigen ist hierbei die Abschnürspannung desjenigen selbstleitenden Feldeffekttransistors, an dessen HV-Gitteranschluss das Schutzelement zwar angeschlossen ist, dessen Driftzone zwischen HV-Kathodenanschluss und HV-Anodenanschluss aber nicht parallel zum Schutzelement geschaltet ist und der damit auch nicht in die Schutzwirkung des Schutzelements fällt.

Die Schutzelement-Durchbruchspannung ist also so zu dimensionieren, dass sie kleiner ist als die um die genannte Abschnürspannung verminderte Summe der Schaltelement-Durchbruchspannungen derjenigen Schaltelemente, denen das Schutzelement parallel geschaltet ist.

Bevorzugte Ausführungsbeispiele werden nunmehr anhand der Zeichnung näher erläutert. Zur Verdeutlichung ist die Zeichnung nicht maßstäblich ausgeführt und gewisse Merkmale sind schematisiert dargestellt. Im Einzelnen zeigen

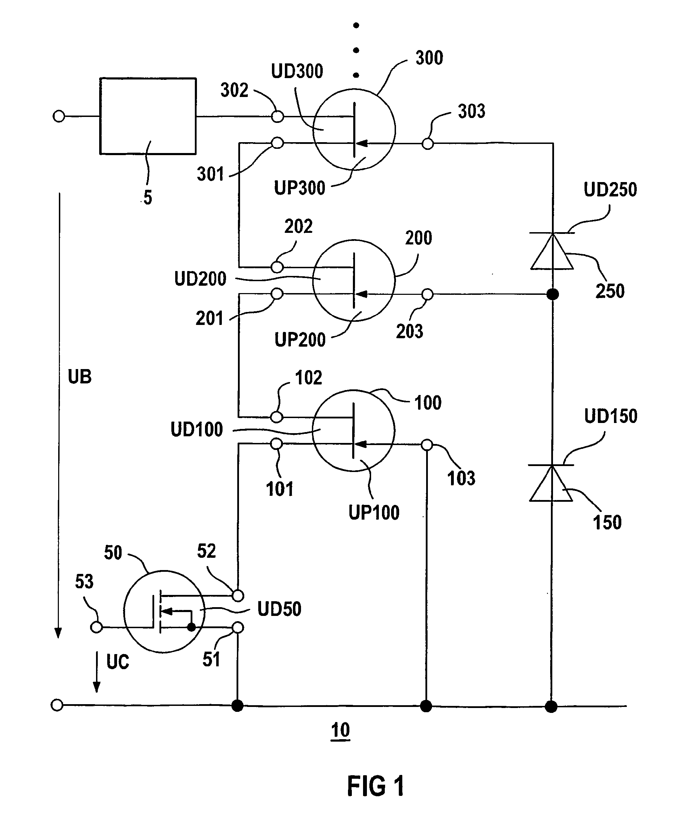

Figur 1 bis Figur 3    Schalteinrichtungen mit Eignung zum Betrieb bei einer hohen Spannung.

Einander entsprechende Teile sind in den Figuren 1 bis 3 mit denselben Bezugszeichen versehen.

In Figur 1 ist eine Schalteinrichtung 10 gezeigt, die zum Zu- und Abschalten einer Last 5 an eine hohe Betriebsspannung UB bestimmt ist. Die Betriebsspannung UB liegt im gezeigten Ausführungsbeispiel bei 3000 V. Als Last kommt z.B. ein in einem drehzahlveränderbaren Antrieb eingesetzter Umrichterzweig in Frage.

Die Schalteinrichtung 10 beinhaltet ein Niedervolt(NV)-Schaltelement in Form eines selbstsperrenden MOSFETs 50 sowie insgesamt drei Hochvolt(HV)-Schaltelemente jeweils in Form eines selbstleitenden Sperrschicht-Feldeffekttransistors (JFET) 100, 200 und 300 sowie zwei Schutzelemente jeweils in Form einer in Silicium realisierten Avalanche-Diode 150 und 250.

Die drei HV-Schaltelemente 100, 200 und 300 haben jeweils einen HV-Kathodenanschluss 101, 201, 301, einen HV-Anodenanschluss 102, 202, 302 und einen HV-Gitteranschluss 103, 203, 303. Der MOSFET 50 hat einen NV-Kathodenanschluss 51, einen NV-Anodenanschluss 52 sowie einen NV-Gitteranschluss 53, wobei der zuletzt genannte HV-Gitteranschluss 53 zum Betrieb an einer Steuerspannung UC bestimmt ist, mittels der die Schalteinrichtung 10 zwischen leitendem und sperrendem Zustand umgeschaltet werden kann.

Im sperrenden, d.h. ausgeschalteten Zustand nehmen im Wesentlichen die drei JFETs 100, 200 und 300 die Betriebsspannung UB auf. Je nach Ausbildung erfolgt eine Aufteilung der Betriebsspannung UB auf die drei JFETs 100, 200 und 300. Im vorliegenden Fall teilt sich die Betriebsspannung UB im Wesentlichen gleichmäßig auf die drei JFETs 100, 200 und 300 auf. In einer anderen nicht dargestellten Ausführungsform ist jedoch eine von der Gleichverteilung abweichenden Spannungsverteilung möglich.

Der MOSFET 50 und der JFET 100 sind in einer sogenannten Kaskoden-Schaltung zusammengeschaltet. Hierzu ist der NV-Anodenanschluss 52 mit dem HV-Kathodenanschluss 101 sowie der NV-Kathodenanschluss 51 mit dem HV-Gitteranschluss 103 elektrisch kurzgeschlossen. In der US 6,157,049 sowie in der EP 0 063 749 B1 ist eine derartige Kaskoden-Schaltung ebenso beschrieben wie ihre Wirkungsweise.

Im Ausführungsbeispiel von Figur 1 ist der MOSFET 50 in Silicium (Si) und der JFET 100 ebenso wie die beiden anderen JFETs 200 und 300 in Siliciumcarbid (SiC) realisiert. Dadurch wird die in Silicium erreichbare hohe Schaltgeschwindigkeit für die Initiierung der Ein-/Ausschaltung und außerdem die im Siliciumcarbid erzielbare hohe Durchbruchspannung ausgenützt.

Im Unterschied zu dem JFET 100, der über die Kaskoden-Beschaltung mit dem NV-MOSFET 50 zur Ein- und Ausschaltung beschaltet ist, ist für die beiden anderen HV-Schaltelemente 200 und 300 keine zusätzliche Beschaltung mit einem NV-Schaltelement, das über eine externe Steuerspannung die Ein-/Ausschaltung initiiert, vorgesehen. Dies bedeutet einerseits eine Reduzierung des schaltungstechnischen Aufwands, andererseits muss die rechtzeitige Ein-/Ausschaltung der JFETs 200 und 300 auf andere Weise sichergestellt werden.

Aus diesem Grund sind die Avalanche-Dioden 150 und 250 zwischen die HV-Gitteranschlüsse 103 und 203 bzw. zwischen die HV-Gitteranschlüsse 203 und 303 geschaltet. Die Avalanche-Dioden 150 und 250 schützen den ihnen parallel geschalteten JFET 100 bzw. 200 vor einem Durchbruch. Hierzu versetzt die Avalanche-Diode 150 den JFET 200 und die Avalanche-Diode 250 den JFET 300 so rechtzeitig in den sperrenden Zustand, dass die JFETs 100 bzw. 200 nicht in den Durchbruch getrieben werden.

Dieses Schaltungsverhalten soll im Folgenden näher erläutert werden. Der MOSFET 50 ist ausgelegt für eine Schaltelement-Durchbruchspannung UD50 von beispielsweise mindestens 50 V. Die JFETs 100, 200 und 33 sind dagegen jeweils ausgelegt für eine in Rückwärtsrichtung anliegende Schaltelement-Durchbruchspannung UD100, UD200 bzw. UD300 von beispielsweise mindestens 1000 V. Außerdem haben die drei JFETs 100, 200 und 300 jeweils eine Abschnürspannung UP100, UP200 bzw. UP300 von etwa 50 V. Ist der HV-Kathodenanschluss 101 gegenüber dem HV-Gitteranschluss 103 des JFETs 100 negativ um den Wert der Abschnürspannung UP100, also um 50 V vorgespannt, so kommt es im JFET 100 zu einer vollständigen Abschnürung des Stromflusskanals zwischen dem HV-Kathodenanschluss 101 und dem HV-Anodenanschluss 102. Der JFET 100 sperrt dann. Die Abschnürung und die Sperrung der anderen beiden JFETs 200 und 300 erfolgt in analoger Weise.

Wird der MOSFET 50 durch einen entsprechenden Wert der Steuerspannung UC in den sperrenden Zustand versetzt, geht auch der JFET 100 aufgrund der Wirkungsweise der Kaskoden-Schaltung in seinen sperrenden Zustand über. Dies bedeutet, dass sich am HV-Anodenanschluss 102 ein zunehmendes Potential bis etwa 1000 V aufbaut, das aber immer noch unterhalb der maximal zulässigen Schaltelement-Durchbruchspannung UD100 liegt. Kurz bevor die Spannung am JFET 100 die Durchschlagspannung UD100 überschreitet, schaltet bei entsprechender Dimensionierung der Avalanche-Diode 150 nämlich auch der JFET 200 in seinen Sperrzustand um. Dies wird gerade dann erreicht, wenn die Avalanche-Diode 150 in ihrer Sperrrichtung ein Durchbruchverhalten aufweist, das ab einer Schutzelement-Durchbruchspannung UD150 einsetzt. Die Schutzelement-Durchbruchspannung UD150 ist dabei kleiner als das um die Abschnürspannung UP200 reduzierte Potential am HV-Anodenanschluss 102. Es gilt also die folgende Dimensionierungsvorschrift:

$$UD150 < (UD50+UD100) - UP200 \qquad (1)$$

Ist die Dimensionierungsvorschrift von Gleichung (1) erfüllt, schaltet der JFET 200 sicher in seinen sperrenden Zustand, bevor es an dem MOSFET 50 oder an dem JFET 100 zu einem unerwünschten und das jeweilige Bauelement schädigenden Durchbruch kommen kann. Im vorliegenden Fall hat die Avalanche-Diode 150 eine Schutzelement-Durchbruchspannung UD150 von etwa 950 V.

Auch für die Avalanche-Diode 250 kann in ähnlicher Weise eine entsprechende Dimensionierungsvorschrift abgeleitet werden. Die Avalanche-Diode 250 ist im Wesentlichen dem JFET 200 parallel geschaltet und soll den JFET 200 vor einem Durchbruch schützen. Bedingung ist hier also, dass der JFET 300 in seinen sperrenden Zustand überführt wird, noch ehe die zwischen dem HV-Kathodenanschluss 201 und dem HV-Anodenanschluss 202 anstehende Spannung größer als die maximal zulässige Durchbruchspannung UD200 wird. In diese zweite Dimensionierungsvorschrift geht die Abschnürspannung UP300, die für eine sichere Abschnürung des JFETs 300 zwischen dem HV-Kathodenanschluss 301 und dem HV-Gitteranschluss 303 erforderlich ist, ein. Für die Avalanche-Diode 250 ergibt sich somit die folgende Dimensionierungsvorschrift:

$$UD250 < UD200 - UP300 \qquad (2)$$

Auch für die Avalanche-Diode 250 ist im Ausführungsbeispiel von Figur 1 eine Schutzelement-Durchbruchspannung UD250 von etwa 950 V vorgesehen.

Die angegebenen Spannungswerte der einzelnen Bauelemente von Figur 1 sind nur als Beispiele zu verstehen. So ist eine andere nicht dargestellte Ausführungsform mit einer Betriebsspannung UB von 10 kV sowie Durchbruchspannungen UD100, UD200 und UD300 von jeweils etwa 3,33 kV möglich. Außerdem ist es bei Bedarf ebenfalls problemlos möglich, weitere HV-Schaltelemente in Form weiterer JFETs sowie weitere Schutzelemente in Form weiterer Avalanche-Dioden in analoger Weise zu ergänzen. Dies kann beispielsweise dann sinnvoll sein, wenn eine höhere Betriebsspannung UB vorliegt oder die JFETs 100, 200 und 300 eine niedrigere als die vorstehend angegebenen Schaltelement-Durchbruchspannungen UD100, UD200 bzw. UD300 aufweisen.

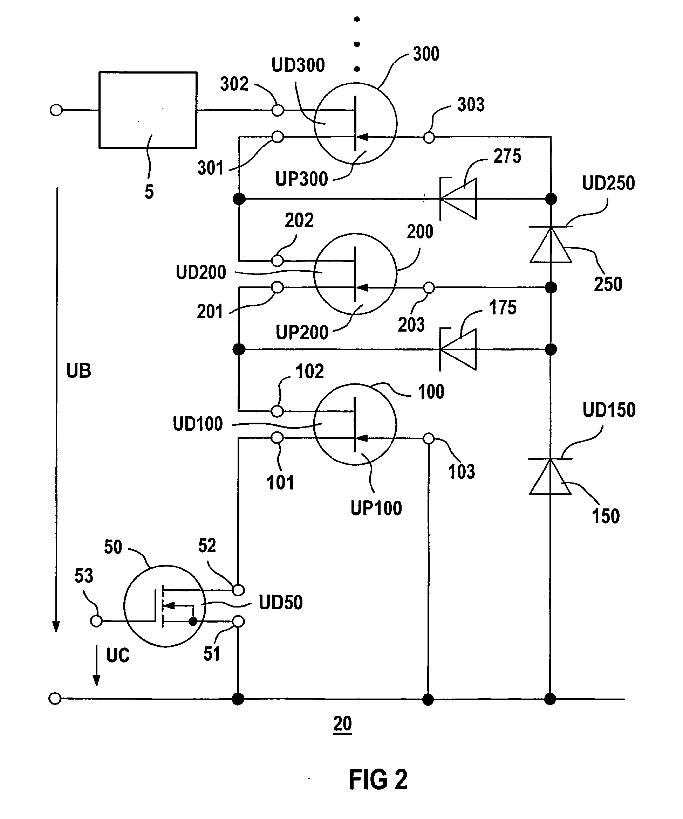

In Figur 2 ist eine weitere Schalteinrichtung 20 dargestellt, die im Wesentlichen auf der Grundvariante der Schalteinrichtung 10 von Figur 1 basiert. Der Unterschied zu Schalteinrichtung 10 besteht darin, dass die Schalteinrichtung 20 von Figur 2 zusätzliche Überspannungsschutzelemente in Form zweier Z-Dioden 175 und 275 aufweist. Bei den Z-Dioden 175 und 275 handelt es sich um handelsübliche Silicium-Bauelemente, die mit einer in gewissen Grenzen wählbaren Z-Spannung UZ175 bzw. UZ275 erhältlich sind.

Die Z-Dioden 175 und 275 sind zwischen den HV-Kathodenanschluss 201 und der HV-Gitteranschluss 203 bzw. zwischen den HV-Kathodenanschluss 301 und den HV-Gitteranschluss 302 geschaltet. Sie dienen dem Überspannungsschutz des JFETs 200 bzw. des JFETs 300. Die Z-Spannungen UZ175 und UZ275 haben in etwa den gleichen Wert wie die Abschnürspannung UP200 bzw. UP300 des durch die jeweilige Z-Diode 175 bzw. 275 zu schützenden JFETs 200 bzw. 300. Im vorliegenden Fall ist für die Z-Spannungen UZ175 und UZ275 also ein Wert in der Größenordnung von etwa 50 V vorgesehen.

Bei einem Wert der Z-Spannung UZ150, der deutlich niedriger als die Abschnürspannung UP200 ist, kann der Fall eintreten, dass der Stromflusskanal im JFET 200 nur unvollständig abgeschnürt wird und der JFET 200 in Folge nur ein vermindertes Sperrverhalten aufweist. Wird dagegen die Z-Spannung UZ175 deutlich größer gewählt als die Abschnürspannung UP200, tritt die eigentlich beabsichtigte Schutzwirkung der Z-Diode 175 nur in eingeschränktem Umfang in Kraft. In diesem Fall bestimmt nämlich eine interne Diode des JFETs 200 zwischen dem HV-Gitteranschluss 203 und dem HV-Kathodenanschluss 201 den wesentlichen Spannungsabfall am JFET 200. Deshalb ist es am günstigsten, wenn der Wert der Z-Spannung UZ175 im Wesentlichen mit dem Wert der Abschnürspannung UP200 übereinstimmt.

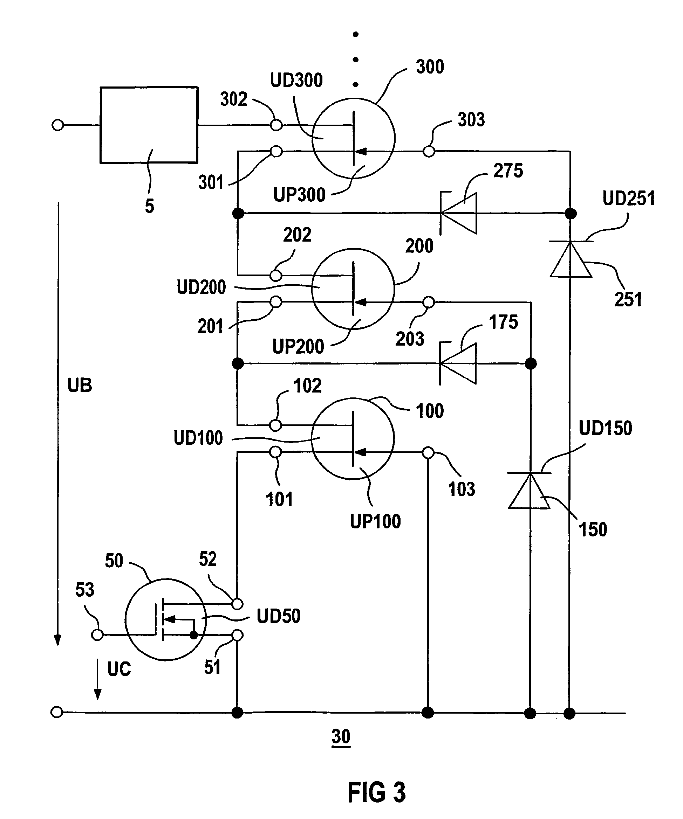

In Figur 3 ist eine weitere Schalteinrichtung 30 gezeigt, die eine andere Abwandlung der Grundvariante der Schalteinrichtung 10 von Figur 1 darstellt. Im Unterschied zur Schalteinrichtung 10 ist eine an den HV-Gitteranschluss 303 des JFETs 300 angeschlossene Avalanche-Diode 251 nicht an den HV-Gitteranschluss 203 des JFETs 200, sondern an den HV-Gitteranschluss 103 des JFETs 100 angeschlossen. An der grundsätzlichen Wirkungsweise der Schutzbeschaltung mittels eines Schutzelements in Form einer Avalanche-Diode 150 und 251 ändert dies jedoch nichts. Um ein rechtzeitiges Umschalten des JFETs 300 in den Sperrzustand sicherzustellen, wird eine Schutzelement-Durchbruchspannung UD251 der Avalanche-Diode 251 entsprechend der Vorschrift:

$$UD251 < (UD50 + UD100 + UD200) - UP300 \qquad (3)$$

gewählt. Im Ausführungsbeispiel von Figur 3 ist folglich ein Wert von 2000 V für die Schutzelement-Durchbruchspannung UD251 vorgesehen. Im Gegensatz zum Ausführungsbeispiel von Figur 1 ist die Avalanche-Diode 251 nicht nur dem JFET 200, sondern auch dem JFET 100 und dem MOSFET 50 parallel geschaltet. Deshalb gehen auch die entsprechenden Schaltelement-Druchbruchspannungen UD50 und UD100 dieser Schaltelemente 50 bzw. 100 in Gleichung (3) ein. Trotz dieser geringfügig modifizierten Dimensionierungsvorschrift für die Avalanche-Diode 251 zeigt die Schaltungseinrichtung 30 jedoch im Prinzip das gleiche Betriebsverhalten wie die Schalteinrichtung 20 oder die Schalteinrichtung 10.

Durch die in den Figuren 1 bis 3 gezeigte Kaskadierung mehrerer Hochvolt-JFETs mit einer Kaskoden-Schaltung aus einem Niedervolt-MOSFET und einem Hochvolt-JFET kann auf einfache Art und Weise und mit geringem schaltungstechnischen Aufwand eine Schalteinrichtung realisiert werden, die bei einer hohen Spannung betrieben werden kann und die insbesondere auch auf sehr einfache Weise durch Hinzuschaltung weiterer Kaskaden-Elemente (= Hochvolt-JFETs) an eine vorgegebene hohe Betriebsspannung angepasst werden kann. Außerdem weisen die beschriebenen Schalteinrichtungen 10, 20 und 30 aufgrund der Verwendung unipolarer Schaltelemente (MOSFET, JFET) eine sehr geringe Ansprechzeit auf und eignen sich deshalb für den Einsatz bei einer hohen Schaltfrequenz. Der Einsatz der unipolaren Bauelemente bedingt darüber hinaus auch sehr niedrige dynamische Verluste.

**Patentansprüche**

1. Schalteinrichtung zum Schalten bei einer hohen Betriebsspannung, umfassend mindestens

   a) ein NV-Schaltelement (50) mit einem NV-Kathodenanschluss (51), einem NV-Anodenanschluss (52) und einem NV-Gitteranschluss (53),
   b) ein erstes HV-Schaltelement (100) mit einem ersten HV-Kathodenanschluss (101), einem ersten HV-Anodenanschluss (102) und einem ersten HV-Gitteranschluss (103),
   c) wobei der NV-Anodenanschluss (52) mit dem ersten HV-Kathodenanschluss (101) und der NV-Kathodenanschluss (51) mit dem ersten HV-Gitteranschluss (103) elektrisch kurzgeschlossen ist,
   **dadurch gekennzeichnet, dass**
   d) mindestens noch ein zweites HV-Schaltelement (200) mit einem zweiten HV-Kathodenanschluss (201), einem zweiten HV-Anodenanschluss (202) und einem zweiten HV-Gitteranschluss (203) vorgesehen ist und
   e) in Reihe zum ersten HV-Schaltelement (100) geschaltet ist,
   f) wobei zwischen den ersten und den zweiten HV-Gitteranschluss (103) bzw. (203) ein erstes Schutzelement (150) geschaltet ist.

2. Schalteinrichtung nach Anspruch 1, bei der ein drittes HV-Schaltelement (300) mit einem dritten HV-Kathodenanschluss (301), einem dritten HV-Anodenanschluss (302) und einem dritten HV-Gitteranschluss (303) vorgesehen ist und in Reihe zu den ersten beiden HV-Schaltelementen (100, 200) geschaltet ist.

3. Schalteinrichtung nach Anspruch 2, bei der ein zweites Schutzelement (250, 251) zwischen den dritten HV-Gitteranschluss (303) und einen der beiden anderen HV-Gitteranschlüsse (103, 203) geschaltet ist.

4. Schalteinrichtung nach einem der vorhergehenden Ansprüche, bei der das Schutzelement (150, 250) so ausgebildet ist, dass es bei einer in Sperrrichtung an dem Schutzelement (150, 250) anliegenden Spannung bis zu einer Schutzelement-Durchbruchspannung (UD150, UD250) stromsperrendes Verhalten und bei einem Spannungswert über der Schutzelement-Durchbruchspannung (UD150, UD250) stromführendes Verhalten aufweist.

5. Verfahren nach einem der vorhergehenden Ansprüche, bei der das Schutzelement (150, 250) als Diode, insbesondere als Avalanche-Diode ausgebildet ist.

6. Schalteinrichtung nach einem der vorhergehenden Ansprüche, bei der mindestens zwischen den zweiten HV-Kathodenanschluss (201) und den zweiten HV-Gitteranschluss (203) ein Überspannungsschutzelement (175) geschaltet ist.

7. Schalteinrichtung nach Anspruch 6, bei der das Überspannungsschutzelement als Z-Diode (175) ausgebildet ist.

8. Schalteinrichtung nach einem der vorhergehenden Ansprüche, bei der zumindest eines der HV-Schaltelemente (100, 200, 300) aus dem Halbleitermaterial Siliciumcarbid besteht.

9. Schalteinrichtung nach einem der vorhergehenden Ansprüche, bei der zumindest eines der HV-Schaltelemente (100, 200, 300) als selbstleitender Feldeffekt-Transistor, insbesondere als selbstleitender Sperrschicht-Feldeffekttransistor, ausgebildet ist.

10. Schalteinrichtung nach Anspruch 4, bei der die Schaltelemente (50, 100, 200, 300) jeweils eine Schaltelement-Durchbruchspannung (UD50, UD100, UD200, UD300) haben und die Schutzelement-Durchbruchspannung (UD150, UD250) jeweils kleiner ist als die Summe der Schaltelement-Durchbruchspannungen (UD50, UD100, UD200, UD300) derjenigen Schaltelemente (50, 100, 200, 300), denen das jeweilige Schutzelement (150, 250) parallel geschaltet ist.

11. Schalteinrichtung nach Anspruch 4 und Anspruch 9, bei der die Schaltelemente (50, 100, 200, 300) jeweils eine Schaltelement-Durchbruchspannung (UD50, UD100, UD200, UD300) und die als selbstleitende Feldeffekttransistoren ausgebildeten HV-Schaltelemente (100, 200, 300) jeweils eine Abschnürspannung (UP100, UP200, UP300) haben und die Schutzelement-Durchbruchspannung (UD150, UD250) jeweils kleiner ist als die Differenz zwischen der Summe der Schaltelement-Durchbruchspannungen (UD50, UD100, UD200) derjenigen Schaltelemente (50, 100, 200), denen das jeweilige Schutzelement (150, 250) parallel geschaltet ist, und der Abschnürspannung (UP200, UP300) desjenigen selbstleitenden Feldeffekttransistors (200, 300), an dessen HV-Gitteranschluss (203, 303) das Schutzelement (150, 250) angeschlossen ist und der nicht parallel zum Schutzelement (150, 250) geschaltet ist.

**Claims**

1. Switching device for switching at a high operating voltage, comprising at least

   a) an LV switching element (50) having an LV cathode terminal (51), an LV anode terminal (52) and an LV grid terminal (53),
   b) a first HV switching element (100) having a first HV cathode terminal (101), a first HV anode terminal (102) and a first HV grid terminal (103),
   c) the LV anode terminal (52) being electrically shortcircuited with the first HV cathode terminal (101) and the LV cathode terminal (51) being electrically shortcircuited with the first HV grid terminal (103),
   **characterized in that**
   d) at least a second HV switching element (200) having a second HV cathode terminal (201), a second HV anode terminal (202) and a second HV grid terminal (203) is additionally provided and
   e) is connected in series with the first HV switching element (100),
   f) a first protection element (150) being connected between the first and second HV grid terminals (103) and (203), respectively.

2. Switching device according to Claim 1, in which a third HV switching element (300) having a third HV cathode terminal (301), a third HV anode terminal (302) and a third HV grid terminal (303) is provided and is connected in series with the first two HV switching elements (100, 200).

3. Switching device according to Claim 2, in which a second protection element (250, 251) is connected between the third HV grid terminal (303) and one of the other two HV grid terminals (103, 203).

4. Switching device according to one of the preceding claims, in which the protection element (150, 250) is designed in such a way that it has current-blocking behavior at a voltage present in the reverse direction across the protection element (150, 250) up to a protection element breakdown voltage (UD150, UD250) and current-carrying behavior at a voltage value above the protection element breakdown voltage (UD150, UD250).

5. Method according to one of the preceding claims, in which the protection element (150, 250) is designed as a diode, in particular as an avalanche diode.

6. Switching device according to one of the preceding claims, in which an overvoltage protection element (175) is connected at least between the second HV cathode terminal (201) and the second HV grid terminal (203).

7. Switching device according to Claim 6, in which the overvoltage protection element is designed as a zener diode (175).

8. Switching device according to one of the preceding claims, in which at least one of the HV switching elements (100, 200, 300) comprises the semiconductor material silicon carbide.

9. Switching device according to one of the preceding claims, in which at least one of the HV switching elements (100, 200, 300) is designed as a normally on field-effect transistor, in particular as a normally on junction field-effect transistor.

10. Switching device according to Claim 4, in which the switching elements (50, 100, 200, 300) in each case have a switching element breakdown voltage (UD50, UD100, UD200, UD300) and the protection element breakdown voltage (UD150, UD250) is in each case less than the sum of the switching element breakdown voltages (UD50, UD100, UD200, UD300) of those switching elements (50, 100, 200, 300) with which the respective protection element (150, 250) is connected in parallel.

11. Switching device according to Claim 4 and Claim 9, in which the switching elements (50, 100, 200, 300) in each case have a switching element breakdown voltage (UD50, UD100, UD200, UD300) and the HV switching elements (100, 200, 300) designed as normally on field-effect transistors in each case have a pinch-off voltage (UP100, UP200, UP300) and the protection element breakdown voltage (UD150, UD250) is in each case less than the difference between the sum of the switching element breakdown voltages (UD50, UD100, UD200) of those switching elements (50, 100, 200) with which the respective protection element (150, 250) is connected in parallel and the pinch-off voltage (UP200, UP300) of that normally on field-effect transistor (200, 300) to whose HV grid terminal (203, 303) the protection element (150, 250) is connected and which is not connected in parallel with the protection element (150, 250).

**Revendications**

1. Dispositif de commutation pour la commutation dans le cas d'une tension de service élevée, comprenant au moins

   a) un élément de commutation basse tension (50) avec une borne de cathode basse tension (51), une borne d'anode basse tension (52) et une borne de grille basse tension (53),
   b) un premier élément de commutation haute tension (100) avec une première borne de cathode haute tension (101), une première borne d'anode haute tension (102) et une première borne de grille haute tension (103),
   c) la borne d'anode basse tension (52) étant court-circuitée électriquement avec la première borne de cathode haute tension (101) et la borne de cathode basse tension (51) étant court-circuitée électriquement avec la première borne de grille haute tension (103),
   **caractérisé en ce que**
   d) au moins encore un second élément de commutation haute tension (200) avec une seconde borne de cathode haute tension (201), une seconde borne d'anode haute tension (202) et une seconde borne de grille haute tension (203) étant prévu et
   e) étant commuté en série avec la première borne de commutation haute tension (100),
   f) un premier élément de protection (150) étant monté entre la première et la seconde bornes de grille haute tension (103) et (203).

2. Dispositif de commutation selon la revendication 1, sur lequel un troisième élément de commutation haute tension (300) avec une troisième borne de cathode haute tension (301), une troisième borne d'anode haute tension (302) et une troisième borne de grille haute tension (303) est prévu et est monté en série avec les deux premiers éléments de commutation haute tension (100, 200).

3. Dispositif de commutation selon la revendication 2, sur lequel un second élément de protection (250, 251) est branché entre la troisième borne de grille haute tension (303) et l'une des deux autres bornes de grille haute tension (103, 203).

4. Dispositif de commutation selon l'une quelconque des revendications précédentes, sur lequel l'élément de protection (150, 250) est réalisé de telle sorte qu'il présente un comportement de blocage de courant dans le cas d'une tension s'appliquant dans le sens de blocage sur l'élément de protection (150, 250) jusqu'à une tension de claquage de l'élément de protection (UD150, UD250) et un comportement véhiculant du courant dans le cas d'une valeur de tension supérieure à la tension de claquage de l'élément de protection (UD150, UD250).

5. Procédé selon l'une quelconque des revendications précédentes, dans lequel l'élément de protection (150, 250) est conçu comme diode, en particulier comme diode à avalanche.

6. Dispositif de commutation selon l'une quelconque des revendications précédentes, sur lequel un élément de protection de surtension (175) est monté au moins entre la seconde borne de cathode haute tension (201) et la seconde borne de grille haute tension (203).

7. Dispositif de commutation selon la revendication 6, sur lequel l'élément de protection de surtension est conçu sous forme de diode Z (175).

8. Dispositif de commutation selon l'une quelconque des revendications précédentes, sur lequel au moins l'un des éléments de commutation haute tension (100, 200, 300) est à base du matériau semi-conducteur qu'est le carbure de silicium.

9. Dispositif de commutation selon l'une quelconque des revendications précédentes, sur lequel au moins l'un des éléments de commutation haute tension (100, 200, 300) est conçu comme transistor à effet de champ autoconducteur, en particulier sous forme de transistor à effet de champ à jonction de grille autoconducteur.

**10.** Dispositif de commutation selon la revendication 4, sur lequel les éléments de commutation (50, 100, 200, 300) ont chacun une tension de claquage (UD50, UD100, UD200, UD300) et la tension de claquage de l'élément de protection (UD150, UD250) est respectivement inférieure à la somme des tensions de claquage (UD50, UD100, UD200, UD300) des éléments de commutation (50, 100, 200, 300), parallèlement auxquels l'élément de protection (150, 250) respectif est monté.

**11.** Dispositif de commutation selon la revendication 4 et la revendication 9, sur lequel les éléments de commutation (50, 100, 200, 300) ont chacun une tension de claquage (UD50, UD100, UD200, UD300) et les éléments de commutation haute tension (100, 200, 300) conçus comme des transistors à effet de champ autoconducteurs ont chacun une tension de blocage (UP100, UP200, UP300) et la tension de claquage d'élément de protection (UD150, UD250) est respectivement inférieure à la différence entre la somme des tensions de claquage (UD50, UD100, UD200) des éléments de commutation (50, 100, 200), parallèlement auxquels l'élément de protection (150, 250) respectif est monté, et la tension de blocage (UP200, UP300) du transistor à effet de champ (200, 300) autoconducteur, à la borne de grille haute tension (203, 303) duquel l'élément de protection (150, 250) est raccordé et qui n'est pas branché parallèlement à l'élément de protection (150, 250).

**FIG 1**

**FIG 2**

**FIG 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6157049 A
- EP 0063749 B1
- JP 61285770 A
- DE 19926109 A1
- US 6034385 A
- DE 19833214 C1